(19) Europäisches Patentamt
European Patent Office
Office européen des brevets

(11) **EP 2 378 281 A1**

(12) **EUROPEAN PATENT APPLICATION**

(43) Date of publication:
**19.10.2011 Bulletin 2011/42**

(51) Int Cl.:
*G01N 24/10* (2006.01)     *G01R 33/60* (2006.01)

(21) Application number: **11001983.3**

(22) Date of filing: **10.03.2011**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br><br>(30) Priority: **31.03.2010  PL 39088710**<br><br>(71) Applicants:<br> • **Politechnika Poznanska**<br>  **61-542 Poznan (PL)**<br> • **Jurga, Kazimierz**<br>  **61-606 Poznan (PL)**<br> • **Baranowski, Mikolaj, Dr.**<br>  **61-465 Poznan (PL)**<br> • **Czechowski, Tomasz**<br>  **61-064 Poznan (PL)**<br> • **Jurga, Jan**<br>  **61-311 Poznan (PL)** | • **Szczesniak, Eugeniusz**<br>  **60-791 Poznan (PL)**<br><br>(72) Inventors:<br> • **Politechnika Poznanska**<br>  **61-542 Poznan (PL)**<br> • **Jurga, Kazimierz**<br>  **61-606 Poznan (PL)**<br> • **Baranowski, Mikolaj, Dr.**<br>  **61-465 Poznan (PL)**<br> • **Czechowski, Tomasz**<br>  **61-064 Poznan (PL)**<br> • **Jurga, Jan**<br>  **61-311 Poznan (PL)**<br> • **Szczesniak, Eugeniusz**<br>  **60-791 Poznan (PL)**<br><br>(74) Representative: **Passowicz, Marek**<br> **ul. Mielzynskiego 27/29**<br> **P.O. Box 85**<br> **60-967 Poznan 9 (PL)** |

(54) **A method to measure electron relaxation times T1 in EPR tomography and a system for applying the method**

(57)     The method of the invention consists in measuring the distribution of the "spin-lattice" relaxation times of electron spins using fast adiabatic transitions and detection of the longitudinal component of the magnetization vector. While affecting the sample, which is placed in the first resonator, with a multicomponent magnetic field there is established, in the second resonator, any amplitude of EPR signals which is proportional to the magnitude of magnetization, recorded in swept conditions in the presence of a magnetic field gradient, thus obtaining a projection image for the relaxation time $T_1$.

The method of the invention is performed by means of a system in which is comprised of: the wave shape generator (1), the generator (2) the modulator (3), the transmitter (4), constant magnetic field coils (5), gradient coils (6), swept coils (7), the first resonator (8), the second resonator (9), the amplifier (10), the second power divider (11), the first detector (12), the second detector (13), the first A/C converter (14), the second A/C converter (15), the computer (16), the first power divider (17), supply terminals (18), the phase shifter (19), the microcontroller (20), the first filter (21) and the second filter (22).

Fig. 3

## Description

The present invention relates to a method to measure electron relaxation times $T_1$ in EPR tomography and to a system for performing the method, for application in oncological treatment.

EPR (electron paramagnetic resonance) imaging is capable of providing data about the pharmacokinetics of free radicals and oxygen concentration in body tissues. Detection of tissue oxygen is very important information for cancer treatment in oncology. Since free radicals are only found at low concentrations in tissues and have a very short life-time, it is assumed that at this stage of study it is necessary to introduce from the outside a free radical type with an appropriately long life-time and at a suitable concentration. Such radical compounds include Lithium phthalocyanine LiPc [H. B. Stone, J. M. Brown, T. L. Phillips and R. M. Sutherland, Radiat. Res. 136 (1993) 422-434, J. J. Jiang, T. Nakashima, K. J. Liu, et al., J. Appl. Physiol. 80 (1996) 552-558] of which the EPR line width is determined to a considerable degree by oxygen concentration in its surroundings. Standard EPR spectrometers operating at microwave frequencies are not useful for EPR imaging due to the depth of penetration of electromagnetic radiation into living matter. Consequently, lower frequencies from the radio frequency (RF) range are used, which results in a decreased signal-to-noise (S/N) ratio.

The imaging of small biological objects is currently based on impulse methods [R. W. Quine, G. W. Rinard, S. S. Eaton, et all, Conc. Magn. Reson. (Magn. Res. Engineer) 15 (2002) 59 - 91; G. G. Maresh, M. Mehring, S. Emid, Physica 138B (1986) 261 - 263] [3, 4] and continuous wave (CW) methods [M. Alecci, S. Dellapenna, A. Sotgui, Rev. Sci. Instrum. 63 (1992) 4263 - 4270; H. J. Halpern, D. P. Spencer, J. van Polen, Rev. Sci. Instrum. 60 (1989) 1040 -1050].

Standard continuous wave imaging methods are based on the use of a magnetic field gradient which is constant during swept time. After each measurement, gradient orientation rotates by a fixed angle depending on the number of projections, with the rotation angle changing within the 0˚-180˚ range for 2D imaging. The minimum measurement time for a single projection is $1 \div 2$ s, however, a low signal-to-noise (S/N) ratio in the presence of the gradient requires signal accumulation which, for *in vivo* imaging, extends measurement time to as long as 30 minutes. It should also be noted that the image obtained by the method only represents the spatial distribution of the free radical, without providing any information on its surroundings. Since the EPR method is considerably more sensitive in terms of detecting changes in the local environment of radicals than MRI (magnetic resonance imaging), therefore EPR is potentially more useful, compared with MRI. To obtain data about the surroundings of the free radical, it is necessary to acquire information not only about the spatial but also spectral distribution. To this aim, an additional spectral-spatial imaging technique is used for each projection separately [S. S. Eaton, G. R. Eaton, Spectroscopy 1 (1986) 32 - 35; U. Ewert, T. Herrling, Chem. Phys. Lett. 129 (1986) 516 - 520; P. Kuppusamy, M. Chzhan, P. H. Weng, Magn. Res. Med. 35 (1996b) 323 - 328; P. C. Lauterbur, D. N. Levin, R. B. Marr, J. Magn. Res. 59 (1984) 536 - 541; M. M. Maltempo, J. Magn. Res. 69 (1986) 156 - 163]. In practice, this means that measurement time is extended to be several times as long, having to perform at least a few additional measurements for each gradient orientation.

A method making it possible to considerably speed up measurements is the Rapid Scan (RS) of the magnetic field [J. P. Joshi, J. R. Ballard, J. A. Rinard, et al., J. Magn. Res. 175 (2005) 44 - 51; J. W. Stoner, D. Szymański, S. S. Eaton, J. Magn. Res. 170 (2004) 127 - 135; M. Tsetlin, A. Dhami, S. S. Eaton, G. R. Eaton, J. Magn. Res. 184 (2007) 157 -168; M. Tsetlin, T. Czechowski, S. S. Eaton, G. R. Eaton, J. Magn. Res. 194 (2008) 212 - 221; M. Tsetlin, T. Czechowski, R. W. Quine, S. S. Eaton, G. R. Eaton , J. Magn. Res. 196 (2009) 48 - 53; R. W. Quine, T. Czechowski, G. R. Eaton, Magn. Res. Eng. 35B (2009) 44 - 58]. Instead of a second modulation, the method consists in a rapid swept of the magnetic field (at frequencies in the range 1 - 20 kHz), which can be performed in the sinusoidal or triangular pattern. The absence of the second modulation eliminates the need for phase detection, which makes it possible to obtain an absorption spectrum rather than its first derivative. This results in reduced measurement times of a single projection, which can be as short as 50 μs. In practice, spectrum accumulation is required due to the low signal-to-noise (S/N) ratio. Despite that, the traditional continuous wave (CW) method is being successfully replaced by the RS technique due to the advantage of multiple measurement time reductions of the latter.

Recent times have also seen the application of the rotational gradient technique in RS-based imaging [S. Subramanian, J. Kościelniak, N. Devasahayam, J. Magn. Res. 186 (2007) 212 - 219], which substantially reduces measurement time. The method makes use of gradient rotation during a magnetic field swept, whereby the gradient rotation frequency should be at least four times as high as the swept frequency. In practical terms, the limitation causes low swept frequencies (around 1 kHz) to be applied.

The usefulness of impulse methods, which are widely used in NMR (nuclear magnetic resonance) imaging, is limited by the very short spin-spin relaxation time $T_2$, and spin-lattice relaxation time $T_1$, for a majority of radicals. One of the most frequently used techniques in EPR impulse diagnostics, i.e., detection of the transverse component of magnetization, is used for measuring the relaxation time $T_2$ and $T_1$. However, as the resonance lines are significantly broadened due to the short relaxation times, such methods are not suitable for EPR imaging. Furthermore, there is the added problem of short relaxation time $T_2$, resulting from the presence of a field gradient which, at significant gradients, will cause free induction decay (FID) during the spectrometer's dead time. The effect makes it difficult or even impossible to perform measurements.

The limitations outlined above do not occur in the new method for measuring the spin-lattice relaxation time $T_1$, using fast adiabatic transitions and detection of the longitudinal component of magnetization.

It is an objective of the present invention to provide a method for measuring electron relaxation times $T_1$, in EPR tomography, based on fast adiabatic transitions with frequency modulation and detection of the longitudinal component of magnetization.

Another objective of the present invention is a system for applying the method, based on a traditional EPR technique with modified Radio Frequency components, enabling quadrature detection using a technique based on frequency modulation to enable the recording of fast adiabatic transitions.

The essence of the method of the present invention is that when applying a multicomponent magnetic field to a sample placed in the first resonator, in the second resonator there is established a amplitude - which is proportional to the magnitude of magnetization - of EPR signals recorded in swept conditions, in the presence of a magnetic field gradient, thus obtaining a projection image of the relaxation time $T_1$.

Preferably, the recorded amplitudes of the EPR signals in the second resonator are set at a repetition time of fast modulation of frequency of a source having any profile of changes which is approximately equal to the relaxation time $T_1$, and suitably higher.

Also preferably, the recorded amplitudes of the EPR signals in the second resonator are established at a repetition time of fast modulation of frequency of a source having any profile of changes which is different from the relaxation time $T_1$, and suitably higher.

Moreover, preferably, the recorded amplitudes of the EPR signals in the second resonator are established at any combination of the repetition times of fast modulation of frequency of a source having any profile of changes.

Also preferably, the recorded amplitudes of the EPR signals in the second resonator are established at a repetition time of fast modulation of a magnetic field having any profile of changes which is approximately equal to the relaxation time $T_1$, and suitably higher, for a constant or variable source frequency.

Also preferably, the recorded amplitudes of the EPR signals in the second resonator are established at a repetition time of fast modulation of a magnetic field having any profile of changes which is different from the relaxation time $T_1$, and suitably higher, for a constant or variable source frequency.

Moreover, preferably, the recorded amplitudes of the EPR signals in the second resonator are established at any combination of the repetition times of fast modulation of a magnetic field having any profile of changes for a constant source frequency.

Also preferably, the recorded amplitudes of the EPR signals in the second resonator are established at a repetition time of fast modulation of a magnetic field having any profile of changes which is approximately equal to the relaxation time $T_1$, and suitably higher, for an increasing frequency of a source having any profile of changes.

Furthermore, preferably, the recorded amplitudes of the EPR signals in the second resonator are established at a repetition time of fast modulation of a magnetic field having any profile of changes which is different from the relaxation time $T_1$, and suitably higher, for an increasing frequency of a source having any profile of changes.

Also preferably, the recorded amplitudes of the EPR signals in the second resonator are established at a repetition time of fast modulation of a magnetic field having any profile of changes which is approximately equal to the relaxation time $T_1$, and suitably higher, for a decreasing frequency of a source having any profile of changes.

Also preferably, the recorded amplitudes of the EPR signals in the second resonator are established at a repetition time of fast modulation of a magnetic field having any profile of changes which is different from the relaxation time $T_1$, and suitably higher, for a decreasing frequency of a source having any profile of changes.

Preferably, the recorded amplitudes of the EPR signals in the second resonator are established at a repetition time of fast modulation of the magnetic field having any profile of changes which is approximately equal to the relaxation time $T_1$, and suitably higher, at any kind of changes in the source frequency.

Preferably, the recorded amplitudes of the EPR signals in the second resonator are established at a repetition time of fast modulation of a magnetic field having any profile of changes which is different from the relaxation time $T_1$, and suitably higher, at any kind of changes in the source frequency.

Moreover, preferably, the recorded amplitudes of the EPR signals in the second resonator are established for any combination of repetition times of fast modulation of a magnetic field having any profile of changes for an increasing frequency of a source having any profile of changes.

Preferably, the recorded amplitudes of the EPR signals in the second resonator are established for any combination of the repetition times of fast modulation of a magnetic field having any profile of changes for a decreasing frequency of a source having any profile of changes.

Also preferably, the recorded amplitudes of the EPR signals in the second resonator are established for any combination of the repetition times of fast modulation of a magnetic field having any profile of changes, for any changes in the source frequency.

Also preferably, the EPR signal is obtained by the fast adiabatic transitions method.

The essence of the method of the invention is that a signal source with a modulated frequency in the radio frequency range is connected to the input of the first resonator while the signal of the second resonator is connected to the detection system of which the output is connected to a computer. One of the computer outputs is connected to the power supply terminals of the swept coils, constant magnetic field coils, and gradient coils, while the second output is connected to a transmitter system.

Preferably, the second resonator is orthogonally positioned with regard to the first one and in parallel with regard to the orientation of the constant magnetic field.

Also preferably, the second resonator is not orthogonally positioned with regard to the first one, irrespective of its position with regard to the orientation of the constant magnetic field.

Owing to the application of the method for the measurement of electron relaxation times $T_1$, in EPR tomography and of the system for performing the method, the following performance and technical results were obtained: the method of the invention eliminates prior-art impulse methods which are limited by the dead time of the transmitter/receiver system, making it difficult or impossible to perform imaging in the presence of strong gradients and radicals with short relaxation times. The method enables an explicit determination of metabolic parameters for the biological test object based on the fact that relaxation time $T_1$, depends on the concentration of oxygen in a radical's environment.

An embodiment of the present invention is illustrated by means of drawings, where Fig. 1 shows source frequency modulation diagrams and their corresponding changes in the magnetization vector for a case where the modulation repetition time is comparable to the relaxation time $T_1$, Fig. 2 shows the same case where the modulation repetition time is five times as long as the relaxation time $T_1$, and Fig. 3 shows an embodiment of the system in the form of a block diagram.

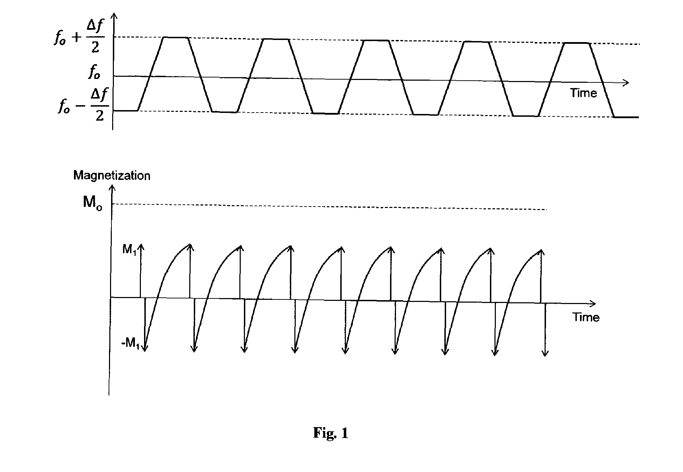

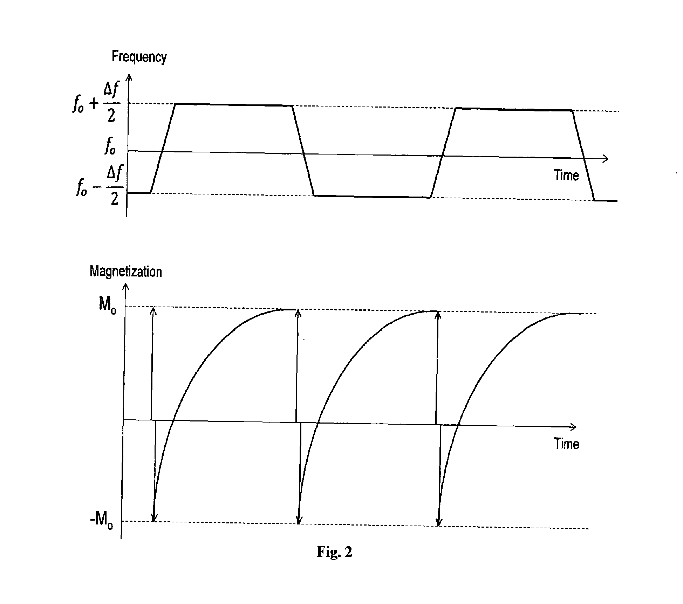

A test sample is placed in a magnetic field constituted by a constant external magnetic field, a gradient field which his either linearly or nonlinearly variable, and a swept magnetic field with a stepwise or sinusoidal or triangular profile or otherwise. In the magnetic field, there is generated a fast modulation of the source frequency with a set repetition time, determined by the resonance condition. For a suitably selected rate of modulation of the source frequency, so-called "fast adiabatic transitions" are observed which invert the magnetization vector in resonance conditions. In the case of periodic transition through the resonance condition, an equilibrium magnetization vector quantity is established during the initial few transitions. Fig. 1 shows the course of the source frequency modulation as well as the behaviour of the magnetization vector in established conditions. If the time interval between the transitions is of the order of the relaxation time $T_1$, then magnetization assumes the value $M_1$. If, on the other hand, the time interval is of the order of $5T_1$, then magnetization assumes the value $M_o$, as shown in Fig. 2. The electron time $T_1$, may then be found from the following relationship:

$$M_1 = M_o \left( \frac{1 - e^{\frac{T}{T_1}}}{1 + e^{\frac{T}{T_1}}} \right) \qquad (1)$$

The sample is placed in the first resonator, which is located in the area of the constant external magnetic field $B_o$, and a specified orientation of the magnetic field gradient. After starting the DDS generator, which generates the source frequency modulation, it is possible to detect the EPR signal originating from electron spins. Detection is carried out by means of the second resonator, of which the axis is directed along the direction of the magnetic field $B_0$. The signal is recorded at a low frequency and its time depends on the time interval between the transitions Fig. 1, 2. After being amplified, the signal is divided into a component which is in the same phase as the field $B_1$ and a component which is shifted by 90˚. The square root of the sum of the squares of such components is the measure $M_1$ for the transition shown in Fig. 1 and $M_0$ for the transition shown in Fig. 2. A change of the field $B_0$, performed by means of the swept coils and suitable gradients in the direction of the axes X, Y and Z enables the spatial differentiation of the distribution of the relaxation time $T_1$.

After finding, in a conventional manner, the EPR signal in the presence of a gradient, the magnetization vectors $M_1$ and $M_0$, are measured and, therefrom, the value of the relaxation time at every point of the spectra recorded for which the EPR signal was recorded is found. Then, after performing, in a conventional manner, a convolution of the resulting data on the relaxation times $T_1$, which preferably have a shape of the Lorentz or/and Gaussian type, projections of the relaxation times $T_1$, are obtained. In the next stage, the procedure is repeated for a different orientation of the magnetic field gradient until measurements are complete. The resulting projections of time $T_1$, thus obtained are used to reconstruct, in a known procedure, an image of its distribution, which directly translates into information about oxygen concentration in the object under examination.

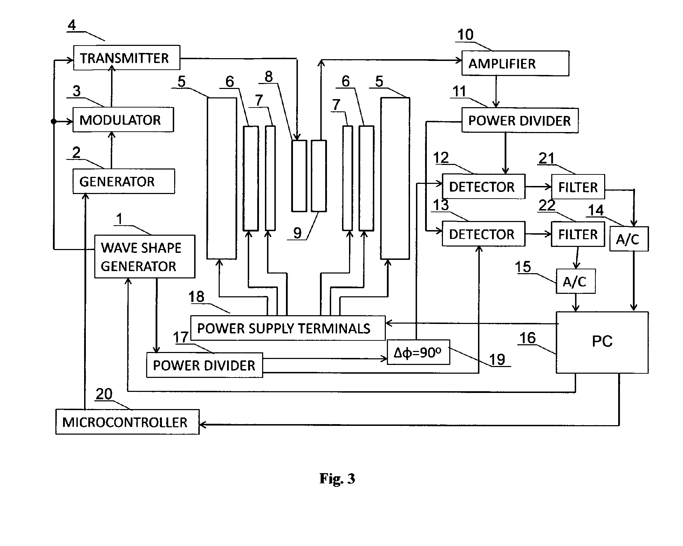

In the system of the invention, the wave shape generator 1 is connected to the input of the modulator 3, of which the output is connected to the transmitter 4 and its input is connected to the generator 2, to the transmitter 4, of which the input is additionally connected to the modulator 3 and its output is connected to the first resonator 8 and the first power divider 17, while its input is connected to the computer 16. The generator 2 is connected to the modulator 3, while its input is connected to the microcontroller 20, of which the input is connected to the computer 16. The output of the second resonator 9 is connected to the amplifier 10 which has a second power divider 11 connected to its output, while the outputs of the latter are connected to the first detector 12, of which the input is connected to the phase shifter 19, of which the input is connected to the first power divider 17 and its output, through the first filter 21, is connected to the first A/C converter 14, and to the second detector 13, of which the input is connected to the first power divider 17 and its output, through the second filter, 22 is connected to the second A/C converter 15. The outputs of both converters are connected to the computer 16, while one of the computer outputs is connected to the power supply terminals 18, which are connected to the constant magnetic field coils 5, gradient coils 6 and swept coils 7 (Fig. 3).

After placing a sample in the resonator 8, which is located between the pole pieces of an electromagnet 5, the wave shape generator 1 is started to determine, by means of the modulator 3, the time of modulation of the source frequency originating from the generator 2; the modulated RF signal is then amplified in the transmitter 4, which is gated with the wave shape 1, and provided to the first resonator 8, which is in electric resonance for a high frequency. In the second resonator 9, which is orthogonally positioned with regard to the first one and is in electric resonance for a low frequency, high frequency is modulated. The recorded signal is then amplified in the amplifier 10, divided in the second power divider 11 and detected in two detectors 12 and 13, and is recorded on the computer 16 after being filtered and digitalized in the A/C converters 14 and 15. Conventional preparatory operations are performed at this stage to identify resonance conditions using a standard SWR (Standing Wave Ratio) meter. Then, using gradient coils 6, the magnetic field gradient is connected of which the orientation determines the time of the EPR signal recording, counted from the swept initialization. After performing measurements for a specified, constant field, $B_o$, by means of swept coils, it undergoes a stepwise change. In addition to signal detection, the computer 16 also controls the course of the experiment, in particular: the wave shape generator 1, microcontroller 20, power supply terminals for the constant magnetic field coils 5, gradient coils 6, and swept coils 7.

Calculation of the magnetization vector quantities $M_1$ and $M_o$ for all the stepwise changes of the magnetic field enables determination of the projection of the relaxation time $T_1$, for the test sample using Formula (1). The duration of measurement of a single projection of the time $T_1$ for a specified orientation of the magnetic field gradient for a radical with a relaxation time of around $10\mu s$ is approximately $200\mu s$. A minimum of 18 projections, recorded for a constant gradient value though varying orientation, are performed to reconstruct a 2D oxygen concentration image. The total time of measurement of all the projections by means of specialist gradient coils is roughly 0.1s. For the acquisition of a full 3D image, the time is around 2 s. If a radical with a relaxation time one order of magnitude lower is used for oxygen concentration imaging, then the total measurement time is shorter by approximately one order of magnitude as well. The result shows that the technique described herein is the fastest EPR imaging method known, while it should also be noted that a significant portion of measurement time is dedicated to the reorientation of the field gradient rather than the measurement itself. By using smaller gradients or slow-rotating gradients with assigned rotations, the time value can be markedly reduced, thus speeding up the measurement. Thanks to such short measurement times, it is possible to combine individual images into a sequence of frames presenting real-time changes of oxygen concentration in a selected tissue, which can substantially expand our knowledge of the processes occurring, e.g., during radiation therapy in oncology. The resolution of the resultant images depends on the gradient applied and on the measurement points constituting the respective projections. Using special filtration techniques, the resolution of images may be ca. 0.5 mm, which is sufficient for precise measurements.

**Claims**

1.  A method to obtain images of electron relaxation times $T_1$ in EPR tomography by measuring the distribution of "spin - lattice" relaxation times of electron spins while applying to a sample a multicomponent magnetic field comprising a constant external magnetic field, a gradient field and a swept field external magnetic field, to a sample placed in the one of two resonators, **wherein** the set modulation, its time and repetition are established in the first resonator, in order to obtain a projection of the relaxation times $T_1$, while in the second resonator, there is established an amplitude of the EPR signals which is proportional to the sample magnetization as measured in fast adiabatic transitions conditions, in the presence of a magnetic field gradient, in the following swept conditions:

    a) while performing modulation by changing the generator's frequency;
    b) while performing modulation by changing the magnetic field;
    c) while performing modulation by any combination of change in the frequency of the generator and the magnetic field,

then from the magnitude of magnetization, as found for various times of repetition of modulation, the value of the relaxation time is found for every point of the spectra recorded, from the following formula:

$$M_1 = M_o \left( \frac{1 - e^{-\frac{T}{T_1}}}{1 + e^{-\frac{T}{T_1}}} \right)$$

where T - denotes the time interval between the modulations, $M_1$ - sample magnetization, as measured for modulation repetitions with the time T, $M_o$ - value of magnetization in equilibrium; whereupon, while performing in a conventional manner, a convolution of the resultant data on the relaxation times $T_1$ which preferably have a shape of the Lorentz and/or Gaussian type, projections of the relaxation times $T_1$ are obtained which may then be used for reconstructing 1D, 2D or 3D images in a known manner.

2. The method according to claim 1, **characterized in that** the recorded amplitudes of the EPR signals in the second resonator are established by repetitions of modulations having any profile of changes which is approximately equal to the relaxation time $T_1$, and then is suitably higher.

3. The method according to claim 1, **characterized in that** the recorded amplitudes of the EPR signals in the second resonator are established by any combination of times of repetition of modulation having any profile of changes.

4. The method according to claim 1, **characterized in that** the recorded amplitudes of the EPR signals in the second resonator are established by repetitions of modulations of the magnetic field having any profile of changes which is approximately equal to the relaxation time $T_1$, and then is suitably higher, at a constant source frequency.

5. The method according to claim 1, **characterized in that** the recorded amplitudes of the EPR signals in the second resonator are established by means of any combination of the times of repetitions of modulations of the magnetic field having any profile of changes at a constant source frequency.

6. The method according to claim 1, **characterized in that** the recorded amplitudes of the EPR signals in the second resonator are established by repetitions of modulations of the magnetic field having any profile of changes which is approximately equal to the relaxation time $T_1$, and then is suitably higher, at an increasing frequency of a source having any profile of changes.

7. The method according to claim 1, **characterized in that** the recorded amplitudes of the EPR signals in the second resonator are established by repetitions of modulations of the magnetic field having any profile of changes which is approximately equal to the relaxation time $T_1$, and then is suitably higher, for a decreasing frequency of a source having any profile of changes.

8. The method according to claim 1, **characterized in that** the recorded amplitudes of the EPR signals in the second resonator are established by repetitions of modulations of the magnetic field having any profile of changes which is approximately equal to the relaxation time $T_1$, and then is suitably higher, at any kind of changes in the source frequency.

9. The method according to claim 1, **characterized in that** the recorded amplitudes of the EPR signals in the second resonator are established by any combination of repetitions of modulations of the magnetic field having any profile of changes at an increasing frequency of a source having any profile of changes.

10. The method according to claim 1, **characterized in that** the recorded amplitudes of the EPR signals in the second resonator are established by any combination of repetitions of modulations of the magnetic field having any profile of changes at a decreasing frequency of a source having any profile of changes.

11. The method according to claim 1, **characterized in that** the recorded amplitudes of the EPR signals in the second resonator are established by any combination of repetitions of modulations of the magnetic field having any profile of changes at any kind of changes in the source frequency.

12. A system enabling the localization of cancerous lesions using EPRI imaging, comprising a transmitter system, two resonators, swept and external and gradient field coils with power supply terminals, as well as a detection system and a control system, according to any claim from 1 to 11, **characterized in that** the wave shape generator 1 is connected to the input of the modulator 3, of which the output is connected to the transmitter 4 and its input is connected to the generator 2, to the transmitter 4, of which the input is additionally connected to the modulator 3 and its output is connected to the first resonator 8 and the first power divider 17, while its input is connected to the computer 16. The generator 2 is connected to the modulator 3, while its input is connected to the microcontroller 20, of which the input is connected to the computer 16. The output of the second resonator 9 is connected to the amplifier 10 which has a second power divider 11 connected to its output, while the outputs of the latter are connected to the first detector 12, of which the input is connected to the phase shifter 19, of which the input is connected to the first power divider 17 and its output, through the first filter 21, is connected to the first A/C converter 14, and to the second detector 13, of which the input is connected to the first power divider 17 and its output, through the second filter, 22 is connected to the second A/C converter 15. The outputs of both converters are connected to the computer 16, while one of the computer outputs is connected to the power supply terminals 18, which are connected to the constant magnetic field coils 5, gradient coils 6 and swept coils 7.

13. The method according to claim 12, **characterized in that** the second resonator 9 is positioned:

   - orthogonally with regard to the first resonator 8, and
   - parallelly with regard to the orientation of the constant magnetic field.

14. The method according to claim 12, **characterized in that** the second resonator 9 is positioned:

   - non-orthogonally with regard to the first resonator 8, and
   - irrespectively with regard to the orientation of the constant magnetic field.

**Fig. 1**

Frequency

$f_o + \dfrac{\Delta f}{2}$

$f_o$

$f_o - \dfrac{\Delta f}{2}$

Time

Magnetization

$M_o$

$-M_o$

Time

**Fig. 2**

**Fig. 3**

Europäisches
Patentamt

European
Patent Office

Office européen
des brevets

# EUROPEAN SEARCH REPORT

Application Number

EP 11 00 1983

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SATO-AKABA H ET AL: "Development and testing of a CW-EPR apparatus for imaging of short-lifetime nitroxyl radicals in mouse head", JOURNAL OF MAGNETIC RESONANCE, ACADEMIC PRESS, ORLANDO, FL, US, vol. 193, no. 2, 1 August 2008 (2008-08-01), pages 191-198, XP023177067, ISSN: 1090-7807, DOI: DOI:10.1016/J.JMR.2008.04.035 [retrieved on 2008-04-29] * chapters 2.1, 2.2, 2.3 * | 1,12 | INV. G01N24/10 G01R33/60 |
| A | DATABASE WPI Week 199129 Thomson Scientific, London, GB; AN 1991-214444 XP002638193, -& SU 1 606 921 A (KAZAN LENIN UNIV) 15 November 1990 (1990-11-15) * abstract * | 1,12 | |
| A | PANAGIOTELIS I ET AL: "T1e* and T2e* maps derived in vivo from the rat using longitudinally detected electron spin resonance phase imaging: application to abdominal oxygen mapping", MAGNETIC RESONANCE IN MEDICINE, ACADEMIC PRESS, DULUTH, MN, US, vol. 46, no. 6, 1 December 2001 (2001-12-01), pages 1223-1232, XP002581071, ISSN: 0740-3194 * see chapter "Materials and Methods" * | 1,12 | TECHNICAL FIELDS SEARCHED (IPC) G01N G01R |

The present search report has been drawn up for all claims

| Place of search | Date of completion of the search | Examiner |
|---|---|---|
| Munich | 23 May 2011 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                EP 11 00 1983

This annex lists the patent family members relating to the patent documents cited in  the above-mentioned European search report.
The members are as contained in the European Patent Office EDP file on
The European Patent Office is in no way liable for these particulars which are merely given for the purpose of information.

23-05-2011

| Patent document cited in search report | Publication date | Patent family member(s) | Publication date |
|---|---|---|---|
| SU 1606921          A | 15-11-1990 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **H. B. STONE ; J. M. BROWN ; T. L. PHILLIPS ; R. M. SUTHERLAND.** *Radiat. Res.,* 1993, vol. 136, 422-434
- **J. J. JIANG ; T. NAKASHIMA ; K. J. LIU et al.** *J. Appl. Physiol.,* 1996, vol. 80, 552-558
- **R. W. QUINE ; G. W. RINARD ; S. S. EATON.** *Conc. Magn. Reson. (Magn. Res. Engineer,* 2002, vol. 15, 59-91
- **G. G. MARESH ; M. MEHRING ; S. EMID.** *Physica,* 1986, vol. 138B, 261-263
- **M. ALECCI ; S. DELLAPENNA ; A. SOTGUI.** *Rev. Sci. Instrum.,* 1992, vol. 63, 4263-4270
- **H. J. HALPERN ; D. P. SPENCER ; J. VAN POLEN.** *Rev. Sci. Instrum.,* 1989, vol. 60, 1040-1050
- **S. S. EATON ; G. R. EATON.** *Spectroscopy,* 1986, vol. 1, 32-35
- **U. EWERT ; T. HERRLING.** *Chem. Phys. Lett.,* 1986, vol. 129, 516-520
- **P. KUPPUSAMY ; M. CHZHAN ; P. H. WENG.** *Magn. Res. Med.,* 1996, vol. 35, 323-328
- **P. C. LAUTERBUR ; D. N. LEVIN ; R. B. MARR.** *J. Magn. Res.,* 1984, vol. 59, 536-541
- **M. M. MALTEMPO.** *J. Magn. Res.,* 1986, vol. 69, 156-163
- **J. P. JOSHI ; J. R. BALLARD ; J. A. RINARD et al.** *J. Magn. Res.,* 2005, vol. 175, 44-51
- **J. W. STONER ; D. SZYMANSKI ; S. S. EATON.** *J. Magn. Res.,* 2004, vol. 170, 127-135
- **M. TSETLIN ; A. DHAMI ; S. S. EATON ; G. R. EATON.** *J. Magn. Res.,* 2007, vol. 184, 157-168
- **M. TSETLIN ; T. CZECHOWSKI ; S. S. EATON ; G. R. EATON.** *J. Magn. Res.,* 2008, vol. 194, 212-221
- **M. TSETLIN ; T. CZECHOWSKI ; R. W. QUINE ; S. S. EATON ; G. R. EATON.** *J. Magn. Res.,* 2009, vol. 196, 48-53
- **R. W. QUINE ; T. CZECHOWSKI ; G. R. EATON.** *Magn. Res. Eng.,* 2009, vol. 35B, 44-58
- **S. SUBRAMANIAN ; J. KOSCIELNIAK ; N. DEVASAHAYAM.** *J. Magn. Res.,* 2007, vol. 186, 212-219